# EUROPEAN PATENT APPLICATION

(11) **EP 4 711 848 A1**
(43) Date of publication of application: **18.03.2026**
(21) Application number: 25191378.6
(22) Date of filing: 23.07.2025
(51) Int. Cl.: G03F 1/24, G03F 1/58

(54) **REFLECTIVE MASK BLANK**

(30) Priority: 14.08.2024 JP 2024135359
(71) Applicant: SHIN-ETSU CHEMICAL CO., LTD.,, Chiyoda-ku, Tokyo 1000005 (JP)
(72) Inventor: KOSAKA, Takuro, Joetsu-shi, 9428601 (JP); OGOSE, Taiga, Joetsu-shi, 9428601 (JP)
(74) Representative: Mewburn Ellis LLP

(57) **Abstract**

A reflective mask blank including a substrate, a multilayer reflection film that is formed on the substrate and reflects exposure light, a protection film that is formed on the multilayer reflection film, and an absorber film that is formed in contact with the protection film and absorbs the exposure light is provided. The reflective mask blank is a material for a reflective mask used in EUV lithography using EUV light as the exposure light. The absorber film includes a main region that occupies not less than 94 % of a thickness of the absorber film, the main region consists of tantalum and nitrogen and is constituted of multiple layers that include at least one low nitrogen content layer having a nitrogen content of not more than 20 at%, and at least one high nitrogen content layer having a nitrogen content of 40 at% to 60 at%.

## Description

### TECHNICAL FIELD

The present invention relates to a reflective mask blank, which is a material for a reflective mask used in manufacture of semiconductor devices such as LSIs or others.

### BACKGROUND

In the manufacturing process of semiconductor devices, photolithography technology in which a transfer mask is irradiated with exposure light, and a circuit pattern formed on the mask is transferred onto a semiconductor substrate (semiconductor wafer) through a reduced projection optical system is repeatedly used. Conventionally, the wavelength of the exposure light has been mainly 193 nm using argon fluoride (ArF) excimer laser light, and a process called multi-patterning in which exposure processes and processing processes are combined multiple times has been adopted to ultimately form patterns having dimensions smaller than the wavelength of the exposure light.

However, according to continuous demands for miniaturization of device patterns, the formation of finer patterns is needed. Therefore, EUV lithography technology, which utilizes, as exposure light, extreme ultraviolet (hereafter referred to as "EUV") light having a shorter wavelength than ArF excimer laser light, has been used. The EUV light is light having a wavelength of about 0.2 to 100 nm, more specifically, light having a wavelength of around 13.5 nm. This EUV light has extremely low transparency to materials. Thus, conventional transmission type projection optical systems and masks cannot be used. Therefore, reflective optical elements are used, and a reflective mask is also used as a mask for pattern transfer.

In the reflective mask, a multilayer reflection film that reflects EUV light is formed on a substrate, and a patterned absorber film that absorbs EUV light is formed on the multilayer reflection film. On the other hand, a material in the state before patterning the absorber film (including a material in the state where a resist film is formed) is called a reflective mask blank, the reflective mask blank is used as a material for the reflective mask. The reflective mask blank generally has a basic structure including a low-thermal expansion substrate, a multilayer reflection film that reflects EUV light and is formed on one of the two main surfaces of the substrate, and an absorber film that absorbs EUV light and is formed thereon.

As the multilayer reflection film, a multilayer reflection film in which molybdenum (Mo) layers and silicon (Si) layers are alternately laminated to obtain a necessary reflectance to EUV light is used. On the other hand, for the absorber film, tantalum (Ta), which has a relatively large extinction coefficient to EUV light, is used (JP 2002-246299 A (Patent Document 1)).

Further, as a protection film for protecting the multilayer reflection film, a ruthenium (Ru) film as described in JP 2002-122981 A (Patent Document 2) is formed on the multilayer reflection film. In some cases, a hard mask film containing chromium (Cr) may be formed on the absorber film as an etching mask for forming a pattern to the absorber film. On the other hand, a backside conducting film is formed on the other main surface of the substrate. As the backside conducting film, a metal nitride film is used for electrostatic chucking, and a film containing mainly chromium (Cr) or tantalum (Ta) is exemplified.

### Citation List

Patent Document 1: JP 2002-246299 A
Patent Document 2: JP 2002-122981 A

### SUMMARY OF THE INVENTION

When a reflective mask is manufactured from a reflective mask blank, the absorber film is partially removed to form a pattern. Therefore, after forming the pattern of the absorber film, stress of the film is released, and the surface shape such as a warpage of the substrate is changed. In order to transfer a fine pattern to a semiconductor substrate with high accuracy by a reflective mask, it is necessary to reduce the change in the surface shape of the substrate, and it is necessary to reduce deformation of the substrate caused by the film stress of the absorber film formed on the substrate before forming the pattern. In addition, high surface roughness reduces sensitivity of defect detection, thus, a surface roughness of the absorber film having a smooth surface is required.

The present invention has been made to solve the above problems. An object of the present invention is to provide a reflective mask brank that has a low film stress, and a low surface roughness of an absorber film, and can provide a reflective mask having good pattern transfer performance in an absorber film and good sensitivity in pattern defect inspection.

With respect to a reflective mask blank including a substrate, a multilayer reflection film, a protection film, an absorber film, the inventors have made earnestly studies to solve the above problems. As a result, the inventors found an absorber film including a main region that consists of tantalum (Ta) and nitrogen (N) and is constituted of multiple layers including at least one low nitrogen content layer having a content of not more than 20 at%, and at least one high nitrogen content layer having a content of not less than 40 at% and not more than 60 at%, and found that the absorber film has good film stress and good surface roughness simultaneously.

In one aspect, the invention provides a reflective mask blank including a substrate, a multilayer reflection film that is formed on the substrate and reflects exposure light, a protection film that is formed on the multilayer reflection film, and an absorber film that is formed in contact with the protection film and absorbs the exposure light, and being a material for a reflective mask used in EUV lithography using EUV light as the exposure light, wherein
the absorber film includes a main region that occupies not less than 94 % of a thickness of the absorber film,
the main region consists of tantalum (Ta) and nitrogen (N), and is constituted of multiple layers that include at least one low nitrogen content layer having a nitrogen content of not more than 20 at%, and at least one high nitrogen content layer having a nitrogen content of not less than 40 at% and not more than 60 at%, respectively.

Preferably, the absorber film consists of the main region only.

Preferably, the absorber film consists of
the main region, and a substrate-side region that is in contact with the substrate-side of the main region,
the main region, and a surface-side region that is in contact with the side remote from the substrate of the main region, or
the main region, a substrate-side region that is in contact with the substrate-side of the main region, and a surface-side region that is in contact with the side remote from the substrate of the main region,
the substrate-side region contains tantalum (Ta), nitrogen (N) and an element contained in the protection film, and has a thickness of not more than 1 nm, and
the surface-side region contains tantalum (Ta), nitrogen (N) and oxygen (O), and has a thickness of not more than 2 nm.

Preferably, the reflective mask blank further includes an etching mask film that is formed in contact with the absorber film.

Preferably, in the reflective mask blank including the etching mask film, the absorber film consists of
the main region, and a substrate-side region that is in contact with the substrate-side of the main region,
the main region, and a surface-side region that is in contact with the side remote from the substrate of the main region, or
the main region, a substrate-side region that is in contact with the substrate-side of the main region, and a surface-side region that is in contact with the side remote from the substrate of the main region,
the substrate-side region contains tantalum (Ta), nitrogen (N) and an element contained in the protection film, and has a thickness of not more than 1 nm, and
the surface-side region contains tantalum (Ta), nitrogen (N) and an element contained in the etching mask film, and has a thickness of not more than 1 nm.

Preferably, in the reflective mask blank including the etching mask film, the surface-side layer further contains oxygen (O).

Preferably, the absorber film has a thickness of not less than 50 nm and not more than 80 nm.

Preferably, in the main region, the layer remotest from the substrate is the high nitrogen content layer.

Preferably, the absorber film has a reflectance of not more than 35% with respect to light having a wavelength of 193 to 260 nm.

Preferably, the absorber film consists of at least one low nitrogen content layer and at least one high nitrogen content layer.

Preferably, in the main region, the layer closest to the substrate is the low nitrogen content layer that has a thickness of not less than 0.3 nm and not more than 2 nm, and each layer other than the layer closest to the substrate is the high nitrogen content layer.

Preferably, the main region has a structure in which the low nitrogen content layers and the high nitrogen content layers are alternately laminated, and each layer has a thickness of not less than 3 nm and not more than 30 nm.

Preferably, the absorber film has a surface roughness Sq of not more than 0.6 nm.

Preferably, the absorber film is a film that causes a warpage change ΔTIR of the substrate in the range of +0.2 µm due to tensile stress to -0.5 µm due to compressive stress when the absorber film is formed on a main surface of a substrate having dimensions of 152 mm square and 6.35 mm thick.

Preferably, the protection film contains ruthenium (Ru).

### ADVANTAGEOUS EFFECTS

The reflective mask blank of the invention includes an absorber film having a small film stress and a low surface roughness. Thus, a reflective mask having good pattern transfer performance and good sensitivity in pattern defect inspection of a pattern of an absorber film can be manufactured.

### BRIEF DESCRIPTION OF THE DRAWINGS

FIG. 1 is a cross-sectional view illustrating an example of one reflective mask blank of the invention.
FIG. 2 is a cross-sectional view illustrating an example of another reflective mask blank of the invention.
FIG. 3 is a cross-sectional view illustrating an example of one main region of an absorber film, and the example that is constituted of two layers, from the substrate-side, a low nitrogen content layer and a high nitrogen content layer.
FIG. 4 is a cross-sectional view illustrating an example of another main region of an absorber film, and the example that is constituted of four layers, from the substrate-side, a low nitrogen content layer, a high nitrogen content layer, a low nitrogen content layer and a high nitrogen content layer.
FIG. 5 is a cross-sectional view illustrating an example of a reflective mask of the invention.

### FURTHER EXPLANATIONS; OPTIONS AND PREFERENCES

A reflective mask blank of the invention includes a substrate, a multilayer reflection film that is formed on the substrate and reflects exposure light, a protection film that is formed on the multilayer reflection film, and an absorber film that is formed on the protection film and absorbs the exposure light.

The reflective mask blank of the invention is suitable for a material for a reflective mask used in EUV lithography using EUV light as exposure light. The light used in EUV lithography using EUV light as exposure light has a wavelength of 13 to 14 nm, and the light is normally light having a wavelength of about 13.5 nm. A reflective mask blank and a reflective mask are also called an EUV mask blank and an EUV mask, respectively.

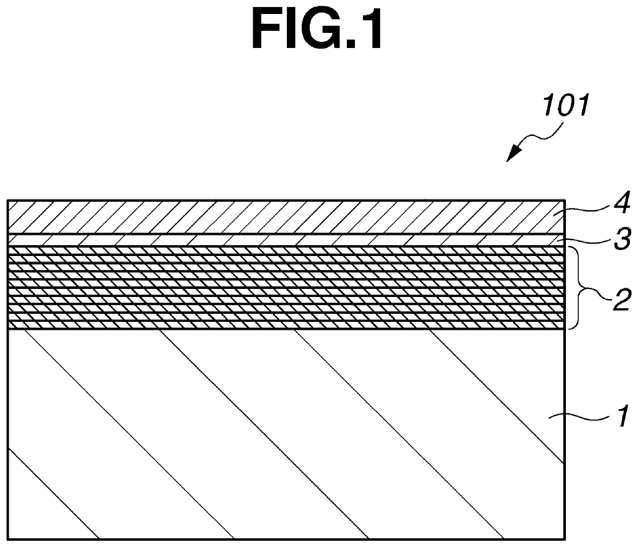

FIG. 1 is a cross-sectional view illustrating an example of one reflective mask blank of the invention. This reflective blank 101 includes, a substrate 1, and on a substrate 1, a multilayer reflection film 2 that is formed in contact with the substrate 1, a protection film 3 that is formed in contact with the multilayer reflection film 2, and an absorber film 4 that is formed in contact with the protection film 3.

The reflective mask blank of the invention may further include another film that is formed in contact with the absorber film, for example, an etching mask film.

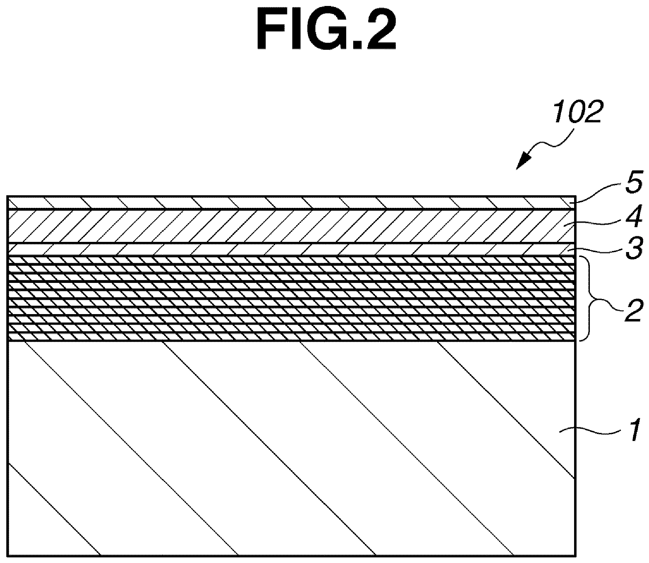

FIG. 2 is a cross-sectional view illustrating an example of another reflective mask blank of the invention. This reflective mask blank 102 includes, a substrate 1, and on a substrate 1, a multilayer reflection film 2 that is formed in contact with the substrate 1, a protection film 3 that is formed in contact with the multilayer reflection film 2, an absorber film 4 that is formed in contact with the protection film 3, and an etching mask film 5 that is formed in contact with the absorber film 4.

The substrate preferably has a low thermal expansion property for exposure using EUV light, and, for example, the substrate is formed of a material having a thermal expansion coefficient of preferably within ±2×10⁻⁸/°C, more preferably within ±5×10⁻⁸/°C. As such a material, a titania-doped quartz glass (SiO₂-TaO₂-based glass) is exemplified. Preferably, a substrate having a sufficiently flattened surface is used, and the substrate has a main surface having a surface roughness of preferably not more than 0.5 nm, more preferably not more than 0.2 nm, in terms of RMS value. Such a surface roughness can be obtained by polishing the substrate. The substate preferably has dimensions of 152 mm square in the main surface, and 6.35 mm in thickness. The substate having the dimensions is so-called called a 6025 substrate which is a substrate having dimensions of 6 inches square in the main surface and 0.25 inches in thickness.

The multilayer reflection film is a film that reflects exposure light in a reflective mask. The multilayer reflection film is formed on one main surface (front surface) of the substrate, preferably in contact with the one main surface of the substrate, however, another film such as an underlaying film may intervene between the one main surface of the substrate, and the multilayer reflection film. The multilayer reflection film has a periodically laminated structure in which high refractive index layers having a relatively high refractive index with respect to exposure light, and low refractive index layers having a relatively low refractive index with respect to exposure light are alternately laminated.

The high refractive index layer is preferably composed of a material containing silicon (Si). The high refractive index layer may contain at least one additive element selected from the group consisting of oxygen (O), nitrogen (N), carbon (C), boron (B) and hydrogen (H), and may be constituted of multiple layers of a layer containing the additive element and a layer not containing the additive element. The high refractive index layer has a thickness of preferably not less than 3.5 nm, more preferably not less than 4 nm, and preferably not more than 4.9 nm, more preferably not more than 4.4 nm.

The low refractive index layer is preferably composed of a material containing molybdenum (Mo). The low refractive index layer may be composed of a material containing ruthenium (Ru). The low refractive index layer may contain at least one additive element selected from the group consisting of oxygen (O), nitrogen (N), carbon (C), boron (B) and hydrogen (H), and may be constituted of multiple layers of a layer containing the additive element and a layer not containing the additive element. The low refractive index layer has a thickness of preferably not less than 2.1 nm, more preferably not less than 2.6 nm, and preferably not more than 3.5 nm, more preferably not more than 3 nm.

The periodically laminated structure may include the high refractive index layer and the low refractive index layer, and may include at least one high refractive index layer and at least one low refractive index layer in one period. The one period includes two or more layers, and may be constituted of, for example, one layer of the high refractive index layer and one layer of the low refractive index layer. Further, the one period may include two or more layers of the high refractive index layer that have different compositions (for example, different composition ratios, different compositions depending on presence or absence of an added element, or others) each other, or two or more layers of the low refractive index layer that have different compositions (for example, different composition ratios, different compositions depending on presence or absence of an added element, or others) each other. In this case, the one period includes not less than three layers, and may include four or five or more layers, however, preferably not more than eight layers. The periodically laminated structure has the periods of preferably not less than 30, and preferably not more than 50, more preferably not more than 40. In the case that the low refractive index layer is composed of a material containing ruthenium (Ru), the layer remotest from the substrate (uppermost layer) in the periodically laminated structure is preferably the high refractive index layer.

The multilayer reflection film having the periodically laminated structure has a thickness that is adjusted depending on the exposure wavelength and the incident angle of exposure light, and the thickness is preferably not less than 200 nm, more preferably not less than 270 nm, and preferably not more than 400 nm, more preferably not more than 290 nm.

Methods for forming the multilayer reflection film include a sputtering method in which the sputtering is performed by applying power to a target and forming plasma of an atmospheric gas (ionizing an atmospheric gas) by the applied power, and an ion beam sputtering method in which an ion beam is irradiated to a target. The sputtering method includes a DC sputtering method in which a direct current voltage is applied to a target, and an RF sputtering method in which a high frequency voltage is applied to a target. The sputtering method is a film formation method in which a voltage is applied to a target with introducing a sputtering gas into a chamber, the gas is ionized, and the sputtering phenomenon caused by the gas ions is utilized. A magnetron sputtering method is particularly advantageous in terms of productivity. The power may be applied to the target by the DC or the RF. The DC includes also pulse sputtering in which a negative bias applied to the target is reversed for a short time to prevent the target from charge-up.

The multilayer reflection film can be formed by a sputtering method using, for example, a sputtering apparatus capable of mounting a plurality of targets. In particular, the multilayer reflection film can be formed with using a target appropriately selected from the group consisting of a molybdenum (Mo) target for forming a layer containing molybdenum (Mo), a ruthenium (Ru) target for forming a layer containing ruthenium (Ru), a silicon (Si) target for forming a layer containing silicon (Si), and others, and using, as a sputtering gas, a rare gas such as helium (He) gas, argon (Ar) gas, krypton (Kr) gas and xenon (Xe) gas.

Further, when the sputtering is reactive sputtering using a reactive gas, for example, a nitrogen-containing gas such as nitrogen (N₂) gas to form a film containing nitrogen (N), an oxygen-containing gas such as oxygen (O₂) gas to form a film containing oxygen (O), a nitrogen oxide gas such as nitrous oxide (N₂O) gas, nitrogen monoxide (NO) gas and nitrogen dioxide (NO₂) gas to form a film containing nitrogen (N) and oxygen (O), a carbon oxide gas such as carbon monoxide (CO) gas and carbon dioxide (CO₂) gas to form a film containing carbon (C) and oxygen (O), a hydrogen-containing gas such as hydrogen (H₂) gas to form a film containing hydrogen (H), or a hydrocarbon gas such as methane (CH₄) gas to form a film containing carbon (C) and hydrogen (H) may be used together with the rare gas.

Further, when a layer containing boron (B) is formed, a molybdenum (Mo) target added with boron (B) (molybdenum boride (MoB) target), a ruthenium (Ru) target added with boron (B) (ruthenium boride (RuB) target), or a silicon (Si) target added with boron (B) (silicon boride (SiB) target) may be used.

The protection film is also called a capping film. The protection film is a film for protecting the multilayer reflection film. The protection film is usually formed in contact with the multilayer reflection film. The protection film is preferably composed of a material containing ruthenium (Ru).

As the material containing ruthenium (Ru), simple ruthenium (Ru) or an alloy containing ruthenium (Ru) and a metal or metalloid different from ruthenium (Ru) is exemplified. As the metal or metalloid different from ruthenium (Ru), niobium (Nb), rhenium (Re), zirconium (Zr), titanium (Ti), chromium (Cr) or silicon (Si) is exemplified. The protection film preferably consists of ruthenium (Ru), or ruthenium (Ru) and niobium (Nb). The protection film has a content of the metal or metalloid different from ruthenium (Ru) of preferably not more than 30 at%, more preferably not more than 20 at%, on average through the entire film. The protection film may have a lower limit of the content of the metal or metalloid different from ruthenium (Ru), and the lower limit is preferably not less than 5 at%, more preferably not less than 10 at%, on average through the entire film, however, not particularly limited thereto.

The protection film may have a single layer structure or a multilayer structure in which multiple layers having different compositions are combined. Each layer constituting the single layer and multiple layers may have a compositionally graded structure in which the composition varies continuously in the thickness direction. Particularly, in the protection film, one or both of the side closest to the multilayer reflection film (in the case of a multilayer structure, the layer closest to the multilayer reflection film), and the side remotest from the multilayer reflection film (in the case of a multilayer structure, the layer remotest from the multilayer reflection film) may consist of ruthenium (Ru).

Further, when the protection film has a multilayer structure or a compositionally graded structure, it is preferable that a content of the metal or metalloid different from ruthenium (Ru) increases from the multilayer reflection film side to the side remote from the multilayer reflection film in a part or all of the thickness direction of the protection film. Particularly, when niobium (Nb) is contained as the metal or metalloid different from ruthenium (Ru), the contained niobium (Nb) is also effective in improving resistance to dry etching using a gas containing chlorine (Cl) and oxygen (O). Thus, it is preferable that the content of niobium (Nb) increases from the multilayer reflection film side to the side remote from the multilayer reflection film in a part or all of the thickness direction of the protection film.

In the invention, as the dry etching using a gas containing chlorine (Cl) and oxygen (O), in particular, dry etching using a gas containing chlorine (Cl₂) gas and oxygen (O₂) gas is exemplified. The gas containing chlorine (Cl) and oxygen (O) may contain a rare gas such as helium (He) gas, argon (Ar) gas, krypton (Kr) gas, and xenon (Xe) gas.

The protection film has a thickness of preferably not less than 2 nm, more preferably not less than 3 nm, and preferably not more than 5 nm, more preferably not more than 4 nm. When the protection film has a thickness of less than 2 nm, the function for protecting the multilayer reflection film may be insufficient. On the other hand, when the protection film has a thickness of more than 5 nm, reflection of EUV light from the multilayer reflection film may be insufficient.

The protection film can be formed by sputtering using a sputtering target appropriately selected from the group consisting of a ruthenium (Ru) target, a target of a metal or metalloid different from ruthenium (Ru), in particular, a niobium (Nb) target, a rhenium (Re) target, a zirconium (Zr) target, a titanium (Ti) target, a chromium (Cr) target, a silicon (Si) target, a target in which two or more selected from the group consisting of niobium (Nb), rhenium (Re), zirconium (Zr), titanium (Ti), chromium (Cr) and silicon (Si) are mixed, a target in which ruthenium (Ru) is mixed with one or more metals or metalloids different from ruthenium (Ru) selected from the group consisting of niobium (Nb), rhenium (Re), zirconium (Zr), titanium (Ti), chromium (Cr) and silicon (Si), and others, and using, as a sputtering gas, a rare gas such as helium (He) gas, argon (Ar) gas, krypton (Kr) gas and xenon (Xe) gas. The sputtering is preferably magnetron sputtering.

Heat treatment may be performed either or both after forming the multilayer reflection film and after forming the protection film. By performing the heat treatment, it is possible to suppress changes in properties such as reflectance to EUV light, even when the multilayer reflection film or the protection film is heated by subsequent heat treatment. If heat treatment is performed many times, it is concerned that defects may be attached, and also from the viewpoint of productivity, it is preferable to perform the heat treatment only after forming the protection film. The heat treatment is preferably performed at a temperature of not less than 120 °C and not more than 150 °C. When the temperature of the heat treatment is higher than 150°C, the reflectance to EUV light may be decreased.

In addition, during the heat treatment, an oxide layer may be formed in the protection film by oxidation of the surface portion of the protection film by oxygen contained in the air. Further, even when the heat treatment is not performed, when the protection film is exposed after forming a pattern of the absorber film, an oxide layer may be formed in the protection film by oxidation of the surface portion of the protection film by oxygen contained in the air. In this regard, the surface portion of the protection film preferably contains ruthenium (Ru) and oxygen (O), or ruthenium (Ru), a metal or semimetal different from ruthenium (Ru), and oxygen (O), more preferably consists of ruthenium (Ru) and oxygen (O), or ruthenium (Ru), a metal or semimetal different from ruthenium (Ru), and oxygen (O). Further, in this regard, a reflectance of the protection film to light used for pattern inspection of the absorber film is preferably set to a reflectance assuming the oxidation of the protection film.

In a reflective mask, the absorber film is a film that absorbs exposure light and reduces reflectance. In the reflective mask, a transfer pattern is formed by a difference in reflectance between a portion where the absorber film is formed and a portion where the absorber film is not formed. In the invention, the absorber film contains tantalum (Ta) and nitrogen (N). The absorber film of the invention is constituted of multiple layers.

The absorber film of the invention includes a main region. The main region consists of tantalum (Ta) and nitrogen (N). Further, the main region is constituted of multiple layers that include at least one low nitrogen content layer (low-nitriding-degree layer) having a nitrogen (N) content of not more than 20 at%, and at least one high nitrogen content layer (high-nitriding-degree layer) having a nitrogen (N) content of not less than 40 at% and not more than 60 at%, respectively. The main region has a thickness that occupies preferably not less than 94 %, more preferably not less than 96%, even more preferably not less than 98%, of a thickness of the absorber film. Particularly, the absorber film preferably consists of the main region only (has a 100% thickness of the absorber film). In the case that the absorber film has a single layer structure, it is difficult to simultaneously control both film stress and surface roughness. Good film stress and good surface roughness can be simultaneously obtained with ensuring necessary absorption performance (extinction coefficient k) of the absorber film to exposure light by a multilayer structure of the absorber film that includes the low nitrogen content layer and the high nitrogen content layer.

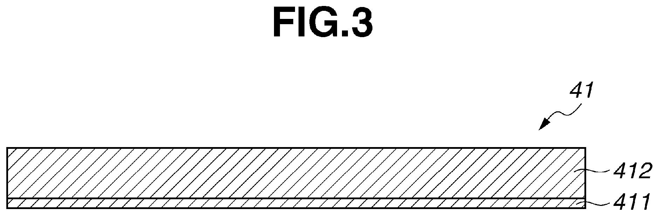

FIG. 3 is a cross-sectional view illustrating an example of one main region of an absorber film, and the example that is constituted of two layers, from the substrate-side, a low nitrogen content layer and a high nitrogen content layer. In this case, the main region 41 consists of a low nitrogen content layer 411 that is formed closest to the substrate, and a high nitrogen content layer 412 that is formed at the side remotest from the substrate. In the case that the absorber film consists of the main region only, the main region 41 corresponds to the absorber film 4.

A film consisting of tantalum (Ta) and nitrogen (N) is easy to have a high surface roughness due to generation (crystallization) of grains or others in the film. Further, the film is easy to have a large film stress. Therefore, the surface roughness and the film stress are generally suppressed to low or small by adding another element such as boron (B), silicon (Si), germanium (Ge), hydrogen (H), oxygen (O) and carbon (C) to form amorphous or microcrystallines. However, meanwhile, the added other element tends to cause defects during film formation, and deteriorates etching characteristics, cleaning resistance, exposure resistance, and others.

The main region of the absorber film of the invention consists of tantalum (Ta) and nitrogen (N), and in the main region, defects are hard to be formed during film formation. Further, the main region has good etching characteristics, cleaning resistance, exposure resistance, and others. Good film stress and good surface roughness can be achieved by multiple layers that include at least one low nitrogen content layer and at least one high nitrogen content layer, respectively, that constitute the main region. Moreover, by the main region constituted of the low nitrogen content layer and the high nitrogen content layer, it is also advantageous in that required absorption performance (extinction coefficient k) can be obtained at a thinner thickness compared with the case of a high nitrogen content layer only.

The main region of the absorber film may include a medium nitrogen content layer (medium-nitriding-degree layer) having a nitrogen (N) content of more than 20 at% and less than 40 at%. However, in the medium nitrogen content layer, crystal grains of various compositions are easy to be formed. Further, when the medium nitrogen content layer is formed by reactive sputtering, the sputtering is difficult to control, thus, the film stress tends to be large, and the surface roughness tends to be high. Therefore, preferably, the main region of the absorber film does not include the medium nitrogen content layer having a nitrogen (N) content of more than 20 at% and less than 40 at%, and the main region of the absorber film preferably consist of at least one low nitrogen content layer and at least one high nitrogen content layer.

The low nitrogen content layer has a nitrogen (N) content of not more than 20 at%, preferably not more than 15 at%. The low nitrogen content layer has a nitrogen (N) content of preferably not less than 5 at%, more preferably not less than 10 at%, however, not particularly limited thereto. On the other hand, the high nitrogen content layer has a nitrogen (N) content of not less than 40 at%, preferably not less than 50 at%, and not more than 60 at%, preferably not more than 55 at%. The low nitrogen content layer and the high nitrogen content layer have tantalum (Ta) contents that correspond to the remainders of the nitrogen (N) contents, respectively.

The main region of the absorber film includes at least one low nitrogen content layer and at least one high nitrogen content layer. The number of the low nitrogen content layer preferably has an upper limit of not more than five layers, and the number of the high nitrogen content layer preferably has an upper limit of not more than five layers. The number of the low nitrogen content layer(s) and the number of the high nitrogen content layer(s) included in the main region of the absorber film may be the same or different.

The low nitrogen content layer has in each a thickness of preferably not less than 0.3 nm, more preferably not less than 1 nm, even more preferably not less than 2 nm, further preferably not less than 3 nm, particular preferably not less than 5 nm, and preferably not more than 30 nm, more preferably not more than 20 nm, even more preferably not more than 10 nm. The high nitrogen content layer has in each a thickness of preferably not less than 3 nm, more preferably not less than 5 nm, and preferably not more than 80nm, more preferably not more than 70 nm, even more preferably not more than 65 nm.

In the main region of the absorber film, the low nitrogen content layer has a total thickness (a thickness of one layer itself in the case of consisting of one layer, or a total of the respective thicknesses of two or more layers in the case consisting of two or more layers) of preferably not less than 0.3 nm, more preferably not less than 1 nm, even more preferably not less than 2 nm, and preferably not more than 30 nm, more preferably not more than 20 nm, even more preferably not more than 10 nm. In the main region of the absorber film, the high nitrogen content layer has a total thickness (a thickness of one layer itself in the case of consisting of one layer, or a total of the respective thicknesses of two or more layers in the case consisting of two or more layers) of preferably not less than 30 nm, more preferably not less than 40 nm, even more preferably not less than 50 nm, and preferably not more than 80 nm, more preferably not more than 70 nm, even more preferably not more than 65 nm.

In inspection of the absorber film, in particular, inspection of a pattern of the absorber film in a reflective mask after forming the pattern of the absorber film, light having a wavelength of 193 to 260 nm is used in some cases. In the inspection, when the low nitrogen content layer is disposed at the remotest from the substrate in the main region of the absorber film, a high reflectance is imparted to the absorber film. From the viewpoint of reducing the reflectance in the inspection of the absorber film and increasing contrast at the inspection wavelength of the absorber film, in the main region of the absorber film, the layer remotest from the substrate is preferably the high nitrogen content layer.

When the layer remotest from the substrate in the main region of the absorber film has a high nitrogen content, reflectance to light having a wavelength of 193 to 260 nm that is used in inspection of the absorber film, in particular, inspection of a pattern of the absorber film in a reflective mask after forming the pattern of the absorber film can be reduced. In this case, the reflectance of the absorber film to light having any wavelength in the range of 193 to 260 nm, preferably to light having every wavelength in the range of 193 to 260 nm (the maximum reflectance in the range of 193 to 260 nm), is preferably not more than 35%, more preferably not more than 32%. Such an absorber film ensures contrast between reflection of light from the multilayer reflection film and protection film, and reflection from the absorber film, and improves inspection sensitivity.

In the main region of the absorber film, the layer closest to the substrate is preferably the low nitrogen content layer. Further, the low nitrogen content layer may be formed at both the side closest to the substrate, and the other portion other than the side closest to the substrate (for example, the central potion in the thickness direction), however, the low nitrogen content layer is preferably formed only at the side closest to the substrate. When the layer closest to the substrate is the low nitrogen content layer, the way of fine crystal grains growth in the high nitrogen content layer that is in contact with the low nitrogen content layer is different from that in the high nitrogen content layer that is directly formed on the protection film. Thus, in the viewpoints of film stress and surface roughness, the low nitrogen content layer closest to the substrate can impart an advantage for obtaining better film stress and better surface roughness, simultaneously.

Particular, when the low nitrogen content layer is thin, preferably has a thickness of not more than 2 nm, more preferably has a thickness of not more than 1 nm, and the layer other than the layer closest to the substrate is the high nitrogen content layer, the absorber film has etching characteristics that are close to those of a single layer film in almost of the absorber film, and an advantage in etching processibility of the absorber film since the low nitrogen content layer having a different nitrogen content from that of the high nitrogen content layer is included only in the thin portion that is in contact with the protection film, and the remainder is the high nitrogen content layer. In this case, the thickness of the low nitrogen content layer has a lower limit of preferably not less than 0.3 nm, more preferably not less than 0.5 nm.

The main region of the absorber film may have a structure in which the low nitrogen content layers and the high nitrogen content layers are alternately laminated (an alternately laminated structure). By the structure in which the low nitrogen content layers and the high nitrogen content layers are alternately laminated, the absorber film has etching characteristics that are close to those of a single layer film, and an advantage in etching processibility of the absorber film. Further, the alternately laminated structure has an advantage in further reducing film stress.

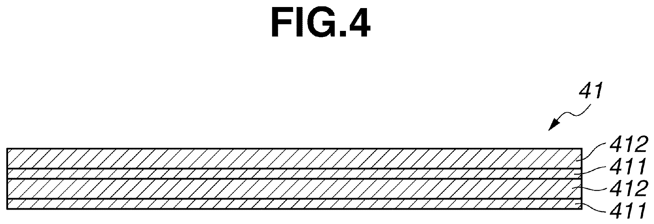

FIG. 4 is a cross-sectional view illustrating an example of another main region of an absorber film, and the example that is constituted of four layers, from the substrate-side, a low nitrogen content layer, a high nitrogen content layer, a low nitrogen content layer and a high nitrogen content layer. In this case, the main region 41 consists of a low nitrogen content layer 411 that is formed closest to the substrate, a high nitrogen content layer 412 that is formed in contact with the low nitrogen content layer 411, a low nitrogen content layer 411 that is formed in contact with the high nitrogen content layer 412, and a high nitrogen content layer 412 that is formed in contact with the low nitrogen content layer 411 and at the side remotest from the substrate. In the case that the absorber film consists of the main region only, the main region 41 corresponds to the absorber film 4.

In the case that the main region of the absorber film has the alternately laminated structure, the absorber film including thinner films has etching characteristics that are close to those of a single layer film. Thus, each of the layers has a thickness of preferably not more than 30 nm, more preferably not more than 15 nm, even more preferably not more than 10nm. On the other hand, in consideration of productivity, each of the layers has a thickness of preferably not less than 3 nm, more preferably not less than 5 nm. Further, in the case that the main region of the absorber film has the alternately laminated structure, the number of the low nitrogen content layers and the high nitrogen content layers are not less than two layers, respectively, and preferably not more than four layers, respectively. The alternately laminated structure includes layers of a total of not less than four layers, and preferably a total of not more than eight layers.

The absorber film and each layer constituting the absorber film, particularly, the main region of the absorber film and each layer constituting the main region can be formed by sputtering, and the sputtering is preferably magnetron sputtering. In particular, the film or layer can be formed with using a sputtering target appropriately selected from the group consisting of a tantalum (Ta) target and a target consisting of tantalum (Ta) and nitrogen (N), by sputtering using, as a sputtering gas, a rare gas such as helium (He) gas, neon (Ne) gas, argon (Ar) gas, krypton (Kr) gas and xenon (Xe) gas, or by reactive sputtering using nitrogen (N₂) gas, as a reactive gas, with the rare gas.

The absorber film preferably consists of the main region only, however, may include the main region, and either or both of a substrate-side region that is in contact with the substrate-side of the main region, and a surface-side region that is in contact with the side remote from the substrate of the main region. In the case that the absorber film includes either or both of the substrate-side region and the surface-side region with the main region, the absorber film preferably consists of the main region and the substrate-side region, the main region and the surface-side region, or the main region, the substrate-side region and the surface-side region.

As the substrate-side region in the absorber film that is formed in contact with the protection film, a region formed by mixing tantalum (Ta) and nitrogen (N) which are elements constituting the main region with an element contained in the protection film is exemplified. In this case, the substrate-side region may contain tantalum (Ta), nitrogen (N) and an element contained in the protection film, and preferably consists of tantalum (Ta), nitrogen (N) and an element contained in the protection film. Such a substrate-side region may be formed over time or by heat treatment the films contacted.

In the case that the substate-side region contains another element other than tantalum (Ta) and nitrogen (N), the region has different etching characteristics from that of the case containing tantalum (Ta) and nitrogen (N) only. Thus, the substate-side region has a thickness of preferably not more than 1 nm, more preferably not more than 0.5 nm.

On the other hand, as the surface-side region, a region (a surface oxidized layer) formed by mixing tantalum (Ta) and nitrogen (N) which are elements constituting the main region with oxygen (O) is exemplified. In this case, the surface-side region may contain tantalum (Ta), nitrogen (N) and oxygen (O), and preferably consists of tantalum (Ta), nitrogen (N) and oxygen (O).

Further, as the surface-side region, a region formed by mixing tantalum (Ta) and nitrogen (N) which are elements constituting the main region with an element contained in a film that is formed in contact with the absorber film (for example, an etching mask film) is exemplified. In this case, the substrate-side region may contain tantalum (Ta), nitrogen (N) and an element contained in the film that is formed in contact with the absorber film, and preferably consists of tantalum (Ta), nitrogen (N) and an element contained in the film that is formed in contact with the absorber film. Such a surface-side region may be formed over time or by heat treatment the films contacted. The surface-side region of this case may further contain oxygen (O).

The surface-side region containing oxygen (O) can be formed by natural oxidation in the air or by oxidation by heat treatment at a temperature of, for example, not more than 200 °C in an atmosphere containing oxygen such as the air. In the case that the surface-side region contains oxygen (O), the surface-side region has an oxygen (O) content of preferably not less than 20 at%, more preferably not less than 40 at%. The surface-side region preferably has a ratio of tantalum (Ta) and nitrogen (N) that is the same ratio of tantalum (Ta) and nitrogen in the portion in contact with the surface-side region in the main region contacting the surface-side region.

In the case that the surface-side region contains another element other than tantalum (Ta) and nitrogen (N), the region has different etching characteristics from that of the case containing tantalum (Ta) and nitrogen (N) only. Particularly, in the case that the surface-side region contains oxygen (O), the region may have less processibility compared with the case containing tantalum (Ta) and nitrogen (N) only. Thus, the surface-side region has a thickness of preferably not more than 2 nm, more preferably not more than 1 nm, even more preferably not more than 0.5 nm.

The absorber film has a surface roughness Sq of preferably not more than 0.6 nm, more preferably not more than 0.5 nm. The absorber film is preferably a film that causes a warpage change ΔTIR to the substrate in the range of +0.2 µm due to tensile stress to -0.5 µm due to compressive stress when the absorber film is formed on a main surface of a substrate having dimensions of 152 mm square and 6.35 mm thick.

The absorber film has a thickness (thickness of the whole of the absorber film) of preferably not less than 50 nm, more preferably not less than 55 nm, and preferably not more than 81 nm, more preferably not more than 80 nm, even more preferably not more than 70 nm, in the viewpoint of obtaining necessary optical properties of the absorber film with respect to exposure light. In the case that the absorber film consists of the main region only, the thickness of the main region corresponds to the thickness of the whole of the absorber film. In the case that the absorber film consists of the main region and either or both of the substrate-side region and the surface-side region, the thickness of the main region corresponds to the remainder in which the thicknesses of the substrate-side region and the surface-side region are excluded from the thickness of the whole of the absorber film.

On the side remote from the substrate of the absorber film, an etching mask film that has different etching characteristics from that of the absorber film may be formed as a hard mask for the absorber film. This etching mask film is a film that functions as a hard mask in dry etching of the absorber film. The etching mask film is preferably formed in contact with the absorber film. The etching mask film may be constituted of a single layer or multiple layers.

The etching mask film preferably contains chromium (Cr), and the etching mask film is preferably composed of a material containing chromium (Cr). The material containing chromium (Cr) has different etching characteristics from that of the absorber film in processing the absorber film that is composed of a material containing tantalum (Ta), and functions as an etching mask in dry etching of the absorber film. Therefore, the material containing chromium (Cr) for the etching mask film is preferably free of tantalum (Ta). Further, the material containing chromium (Cr) for the etching mask film is preferably free of carbon (C). Examples of the materials containing chromium (Cr) include simple Cr, CrO, CrN and CrON.

Since the etching mask film may not function as a hard mask in the case being too thin, and may be deteriorated in processing properties in the case being too thick, the etching mask film has a thickness of preferably not less than 1 nm, more preferably not less than 2 nm, even more preferably not less than 5 nm, and preferably not more than 20 nm, more preferably not more than 10 nm, however, not particularly limited thereto.

The etching mask film can be formed by sputtering. In particular, the film can be formed with using a sputtering target appropriately selected from the group consisting of a chromium (Cr) target and a chromium (Cr) compound target (a target containing chromium (Cr), and oxygen (O), nitrogen (N) or others), by sputtering using, as a sputtering gas, a rare gas such as helium (He) gas, argon (Ar) gas, krypton (Kr) gas and xenon (Xe) gas, or by reactive sputtering using a reactive gas such as an oxygen-containing gas and/or a nitrogen-containing gas, in particular, oxygen (O₂) gas, nitrogen (N₂) gas and/or nitrogen oxide (N₂O, NO, NO₂) gases, with the rare gas. The sputtering is preferably magnetron sputtering.

A conductive film (back-surface conducting film) used for electrostatically chucking the reflective mask to an exposure apparatus (for example, an EUV scanner) may be formed on the other main surface (back surface) opposite to one main surface of the substrate, preferably in contact with the other main surface.

The back-surface conducting film preferably has a sheet resistance of not more than 100 Ω/square, and a material for the film is not particularly limited. As the material for the back-surface conducting film, a material containing tantalum (Ta) or chromium (Cr) is exemplified. Further, the material containing tantalum (Ta) may contain oxygen (O), nitrogen (N), carbon (C), boron (B) or others, and the material containing chromium (Cr) may contain oxygen (O), nitrogen (N), carbon (C) or others. Examples of the materials containing tantalum (Ta) include simple Ta, and a tantalum (Ta) compound such as TaO, TaN, TaON, TaC, TaCN, TaCO, TaCON, TaB, TaOB, TaNB, TaONB, TaCB, TaCNB, TaCOB and TaCONB. Examples of the materials containing chromium (Cr) include simple Cr, and a chromium (Cr) compound such as CrO, CrN, CrON, CrC, CrCN, CrCO and CrCON.

The back-surface conducting film normally has a thickness of about 20 to 300 nm, however, not particularly limited thereto as long as the film has a function for electrostatically chucking. The thickness of the back-surface conducting film is preferably set to such a thickness that film stress of the back-surface conducting film is balanced with that of the films and film pattern formed on one main surface (front surface) side after forming a reflective mask, i.e., after forming a pattern of the absorber film. The back-surface conducting film may be formed before forming the multilayer reflection film, or after forming all of the films formed on the substrate at the side of the multilayer reflection film. Alternatively, the back-surface conducting film may be formed after forming a part of the films formed on the substrate at the side of the multilayer reflection film, and then the remaining film(s) at the side of the multilayer reflection film may be formed. The back-surface conducting film may be formed, for example, by magnetron sputtering.

The reflective mask blank of the invention may include a resist film formed on the side remotest from the substrate. The resist film is preferably an electron beam (EB) resist.

From the reflective mask blank, for example, a reflective mask including a substrate, a multilayer reflection film that is formed on one main surface of the substrate, a protection film that is formed in contact with the multilayer reflection film, and a pattern of an absorber film (absorber film pattern) that is formed in contact with the protection film can be manufactured. In a reflective mask, a transfer pattern is formed by difference in reflectance between a portion where the absorber film is formed and a portion where the absorber film is not formed.

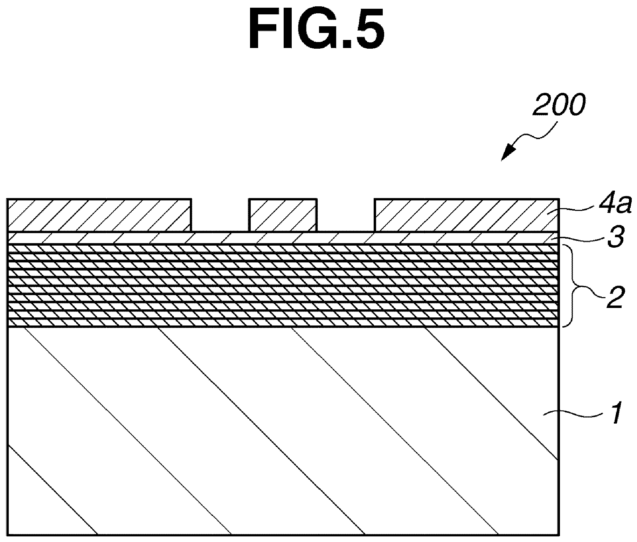

FIG. 5 is a cross-sectional view illustrating an example of a reflective mask of the invention. This reflective mask 200 includes a substrate 1, on the substrate 1, a multilayer reflection film 2 that is formed in contact with the substrate 1, a protection film 3 that is formed in contact with the multilayer reflection film 2, and a pattern of an absorber film 4a that is formed in contact with the protection film 3.

The reflective mask of the invention can be manufactured by the method including the steps of:
preparing a reflective mask blank,
forming a resist film on the absorber film, if needed,
forming a resist pattern from the resist film on the absorber film,
forming a pattern of the absorber film by etching the absorber film with using the resist pattern as an etching mask, and
removing the resist pattern.

Further, the reflective mask of the invention can be manufactured by the method including the steps of:
preparing a reflective mask blank,
forming a resist film on the etching mask film, if needed,
forming a resist pattern from the resist film on the etching mask film,
forming a pattern of the etching mask film by etching the etching mask film with using the resist pattern as an etching mask,
forming a pattern of the absorber film by etching the absorber film with using the pattern of the etching mask film as an etching mask,
removing the resist pattern, and
removing the pattern of the etching mask film.

The absorber film can be etched by dry etching using a gas containing chlorine (Cl) or a gas containing fluorine (F). The etching mask film containing chromium (Cr) can be etched by dry etching using a gas containing chlorine (Cl) and oxygen (O) to form the pattern of the etching mask film. After forming the pattern of the absorber film, the pattern of the etching mask film can be removed by dry etching using a gas containing chlorine (Cl) and oxygen (O).

The resist pattern can be removed by a sulfuric acid/hydrogen peroxide mixture (SPM).

### EXAMPLES

Examples of the invention are given below by way of illustration and not by way of limitation.

### Example 1

A multilayer reflection film having a thickness of 284 nm was formed by DC magnetron sputtering using a molybdenum (Mo) target and a silicon (Si) target on a main surface of a low thermal expansion glass substrate (SiO₂-TiO₂-based glass substrate) having dimensions of 152 mm squire and 6.35 mm thick with facing the both targets and the main surface of the substrate while rotating the substrate. Each of the targets was attached to a sputtering apparatus capable of mounting two targets and discharging the targets one by one or both simultaneously, and the substrate was placed therein.

First, a silicon (Si) layer having a thickness of 4 nm was formed by applying power to the silicon (Si) target while feeding argon (Ar) gas into a chamber, and then the application of power to the silicon (Si) target was suspended. Next, a molybdenum (Mo) layer having a thickness of 3 nm was formed by applying power to the molybdenum (Mo) target while feeding argon (Ar) gas into the chamber, and then the application of power to the molybdenum (Mo) target was suspended. The operation (one cycle) of forming the silicon (Si) layer and the molybdenum (Mo) layer was repeated 40 cycles. Finally, after forming the molybdenum (Mo) layer for the 40th cycle, a silicon (Si) layer having a thickness of 4 nm was formed by the above method to form the multilayer reflection film.

Next, a protection film was formed by DC magnetron sputtering using a ruthenium (Ru) target and a niobium (Nb) target on the multilayer reflection film with facing the both targets and the main surface of the substrate while rotating the substrate. Each of the targets was attached to another sputtering apparatus capable of mounting two targets and discharging the targets one by one or both simultaneously, and after the multilayer reflection film was formed, the substrate on which the multilayer reflection film had been formed was placed therein from the sputtering apparatus in which the multilayer reflection film had been formed through a transport path that maintained a vacuum state without being taken out into the air.

First, a film consisting of RuNb and having a compositional gradation in which niobium (Nb) increases in the thickness direction and a thickness of 3.9 nm was formed by applying powers to a ruthenium (Ru) target and a niobium (Nb) target simultaneously with feeding argon (Ar) gas into a chamber while gradually increasing the power applied to the niobium (Nb) target over time.

Next, the substrate on which the multilayer reflection film and the protection film were formed was subjected to heat treatment in the air atmosphere at 150 °C for 15 minutes by a hot plate type heating equipment to oxidize the surface of the protection film.

Next, an absorber film was formed by DC magnetron sputtering using a tantalum (Ta) target on the protection film with facing the target and the main surface of the substrate while rotating the substrate. The target was attached to the other sputtering apparatus, and after the protection film was formed, the substrate on which the multilayer reflection film and the protection film had been formed was placed therein from the sputtering apparatus in which the protection film had been formed through a transport path that maintained a vacuum state without being taken out into the air.

First, as a low nitrogen content layer, a layer having a thickness of 0.5 nm was formed by applying a power (1800W) to the tantalum (Ta) target with feeding argon (Ar) gas (45 vol%), xenon (Xe) gas (18 vol%) and nitrogen (N₂) gas (37 vol%) into a chamber at a pressure of 0.13 Pa inside the chamber.

Next, as a high nitrogen content layer, a layer having a thickness of 69.5 nm was formed by applying a power (1800W) to the tantalum (Ta) target with feeding argon (Ar) gas (40 vol%) and nitrogen (N₂) gas (60 vol%) into the chamber at a pressure of 0.48 Pa inside the chamber. As a result, a reflective mask blank including an absorber film having a thickness of 70 nm that consists of one low nitrogen content layer (the layer closest to the substrate), and one high nitrogen content layer (the layer remotest from the substrate) was obtained.

The composition of the obtained absorber film was measured by an X-ray photoelectron spectroscopy (XPS) instrument (K-Alpha, manufactured by Thermo Fisher Scientific). The low nitrogen content layer had a tantalum (Ta) content of 85 at% and a nitrogen (N) content of 15 at%, and the high nitrogen content layer had a tantalum (Ta) content of 45 at% and a nitrogen (N) content of 55 at%.

Before and after forming the absorber film, warpages (TIR) within a 142 mm square at the central portion of the substrate surface were measured by a flatness tester (Tropel Ultra Flat 200Mask, manufactured by CORNING), and the change (ΔTIR) in warpages before and after forming the absorber film was calculated. The ΔTIR was -0.32 µm (compressive stress).

The surface roughness Sq (root mean square height) of the obtained absorber film was measured by an atomic force microscope (AFM). The surface roughness Sq was 0.40 nm. The reflectance of the obtained absorber film was measured, and the maximum reflectance in the range of 193 to 260 nm was 34.5%.

### Example 2

A reflective mask blank was obtained in the same manner as in Example 1, except that an absorber film having a thickness of 60 nm and consisting of three low nitrogen content layers having a thickness of 10 nm in each that were formed in the same manner as in Example 1, and three high nitrogen content layers having a thickness of 10 nm in each that were formed in the same manner as in Example 1 was formed, initially forming the low nitrogen content layer, by alternately laminating the total of six layers.

The change (ΔTIR) in warpages, the surface roughness Sq, and the reflectance were evaluated in the same manner as in Example 1. The change (ΔTIR) in warpages was - 0.35 µm (compressive stress), the surface roughness Sq was 0.32 nm, and the maximum reflectance in the range of 193 to 260 nm was 33.8%.

### Comparative Example 1

A reflective mask blank was obtained in the same manner as in Example 1, except that an absorber film consisting of a single layer of the high nitrogen content layer having a thickness of 70 nm that was formed in the same manner as in Example 1.

The change in warpage (ΔTIR), the surface roughness Sq, and the reflectance were evaluated in the same manner as in Example 1. The change in warpage (ΔTIR) was -0.61 µm (compressive stress), the surface roughness Sq was 0.62 nm, and the maximum reflectance in the range of 193 to 260 nm was 34.5%. This absorber film consisting of a single layer of the high nitrogen content layer had a high surface roughness Sq.

### Comparative Example 2

A reflective mask blank was obtained in the same manner as in Example 1, except that an absorber film consisting of a single layer of the low nitrogen content layer having a thickness of 70 nm that was formed in the same manner as in Example 1.

The change (ΔTIR) in warpages, the surface roughness Sq, and the reflectance were evaluated in the same manner as in Example 1. The change (ΔTIR) in warpages was - 0.62 µm (compressive stress), the surface roughness Sq was 0.26 nm, and the maximum reflectance in the range of 193 to 260 nm was 39.8%. This absorber film consisting of a single layer of the low nitrogen content layer had a large film stress.

### Example 3

A multilayer reflection film was formed on a main surface of a low thermal expansion glass substrate (SiO₂-TiO₂-based glass substrate) having dimensions of 152 mm squire and 6.35 mm thick in the same manner as in Example 1, and a protection film was formed on the multilayer reflection film in the same manner as in Example 1.

Next, an absorber film was formed by DC magnetron sputtering using a tantalum (Ta) target on the protection film with facing the target and the main surface of the substrate while rotating the substrate. The target was attached to the other sputtering apparatus, and after the protection film was formed, the substrate on which the multilayer reflection film and the protection film had been formed was placed therein from the sputtering apparatus in which the protection film had been formed through a transport path that maintained a vacuum state without being taken out into the air.

First, as a low nitrogen content layer, a layer having a thickness of 31 nm was formed by applying a power (1800W) to the tantalum (Ta) target with feeding xenon (Xe) gas (32 vol%) and nitrogen (N₂) gas (68 vol%) into a chamber at a pressure of 0.11 Pa inside the chamber.

Next, as a high nitrogen content layer, a layer having a thickness of 31 nm was formed by applying a power (1800W) to the tantalum (Ta) target with feeding argon (Ar) gas (58 vol%) and nitrogen (N₂) gas (42 vol%) into the chamber at a pressure of 0.41 Pa inside the chamber. As a result, a reflective mask blank including an absorber film having a thickness of 62 nm that consists of one low nitrogen content layer (the layer closest to the substrate), and one high nitrogen content layer (the layer remotest from the substrate) was obtained.

The composition of the obtained absorber film was measured in the same manner as in Example 1. The low nitrogen content layer had a tantalum (Ta) content of 80 at% and a nitrogen (N) content of 20 at%, and the high nitrogen content layer had a tantalum (Ta) content of 55 at% and a nitrogen (N) content of 45 at%.

The change (ΔTIR) in warpages, the surface roughness Sq, and the reflectance were evaluated in the same manner as in Example 1. The change (ΔTIR) in warpages was - 0.15 µm (compressive stress), the surface roughness Sq was 0.42 nm, and the maximum reflectance in the range of 193 to 260 nm was 31.9%.

### Example 4

A reflective mask blank was obtained in the same manner as in Example 3, except that an absorber film having a thickness of 60 nm and consisting of two low nitrogen content layers having a thickness of 15 nm in each that were formed in the same manner as in Example 3, and two high nitrogen content layers having a thickness of 15 nm in each that were formed in the same manner as in Example 3 was formed, initially forming the low nitrogen content layer, by alternately laminating the total of four layers.

The change (ΔTIR) in warpages, the surface roughness Sq, and the reflectance were evaluated in the same manner as in Example 1. The change (ΔTIR) in warpages was - 0.11 µm (compressive stress), the surface roughness Sq was 0.60 nm, and the maximum reflectance in the range of 193 to 260 nm was 30.4%.

### Comparative Example 3

A reflective mask blank was obtained in the same manner as in Example 3, except that an absorber film consisting of a single layer of the high nitrogen content layer having a thickness of 60 nm that was formed in the same manner as in Example 3.

The change (ΔTIR) in warpages, the surface roughness Sq, and the reflectance were evaluated in the same manner as in Example 1. The change (ΔTIR) in warpages was - 0.86 µm (compressive stress), the surface roughness Sq was 0.42 nm, and the maximum reflectance in the range of 193 to 260 nm was 31.9%. This absorber film consisting of a single layer of the high nitrogen content layer had a large film stress.

### Comparative Example 4

A reflective mask blank was obtained in the same manner as in Example 3, except that an absorber film consisting of a single layer of the low nitrogen content layer having a thickness of 60 nm that was formed in the same manner as in Example 3.

The change in warpage (ΔTIR), the surface roughness Sq, and the reflectance were evaluated in the same manner as in Example 1. The change in warpage (ΔTIR) was +0.64 µm (tensile stress), the surface roughness Sq was 0.38 nm, and the maximum reflectance in the range of 193 to 260 nm was 37.0%. This absorber film consisting of a single layer of the low nitrogen content layer had a large film stress and a high reflectance.

### Comparative Example 5

A multilayer reflection film was formed on a main surface of a low thermal expansion glass substrate (SiO₂-TiO₂-based glass substrate) having dimensions of 152 mm squire and 6.35 mm thick in the same manner as in Example 1, and a protection film was formed on the multilayer reflection film in the same manner as in Example 1.

Next, an absorber film was formed by DC magnetron sputtering using a tantalum (Ta) target on the protection film with facing the target and the main surface of the substrate while rotating the substrate. The target was attached to the other sputtering apparatus, and after the protection film was formed, the substrate on which the multilayer reflection film and the protection film had been formed was placed therein from the sputtering apparatus in which the protection film had been formed through a transport path that maintained a vacuum state without being taken out into the air.

Next, as a single layer of a medium nitrogen content layer having a thickness of 61 nm was formed by applying a power (1800W) to the tantalum (Ta) target with feeding argon (Ar) gas (41 vol%), xenon (Xe) gas (12 vol%) and nitrogen (N₂) gas (47 vol%) into a chamber at a pressure of 0.16 Pa inside the chamber to obtain a reflective mask blank.

The composition of the obtained absorber film was measured in the same manner as in Example 1. The tantalum (Ta) content was 75 at% and the nitrogen (N) content was 25 at%.

The change (ΔTIR) in warpages, the surface roughness Sq, and the reflectance were evaluated in the same manner as in Example 1. The change (ΔTIR) in warpages was - 1.40 µm (compressive stress), the surface roughness Sq was 0.30 nm, and the maximum reflectance in the range of 193 to 260 nm was 33.8%. This absorber film consisting of a single layer of the medium nitrogen content layer had a significantly large film stress.

## Claims

1. A reflective mask blank comprising a substrate, a multilayer reflection film that is formed on the substrate and reflects exposure light, a protection film that is formed on the multilayer reflection film, and an absorber film that is formed in contact with the protection film and absorbs the exposure light, and being a material for a reflective mask used in EUV lithography using EUV light as the exposure light, wherein
the absorber film comprises a main region that occupies not less than 94 % of a thickness of the absorber film,
the main region consists of tantalum (Ta) and nitrogen (N), and is constituted of multiple layers that comprise at least one low nitrogen content layer having a nitrogen content of not more than 20 at%, and at least one high nitrogen content layer having a nitrogen content of not less than 40 at% and not more than 60 at%, respectively.

2. The reflective mask blank of claim 1 wherein the absorber film consists of the main region only.

3. The reflective mask blank of claim 1 or 2 wherein the absorber film consists of
the main region, and a substrate-side region that is in contact with the substrate-side of the main region,
the main region, and a surface-side region that is in contact with the side remote from the substrate of the main region, or
the main region, a substrate-side region that is in contact with the substrate-side of the main region, and a surface-side region that is in contact with the side remote from the substrate of the main region,
the substrate-side region comprises tantalum (Ta), nitrogen (N) and an element comprised in the protection film, and has a thickness of not more than 1 nm, and
the surface-side region comprises tantalum (Ta), nitrogen (N) and oxygen (O), and has a thickness of not more than 2 nm.

4. The reflective mask blank of any one of claims 1 to 3 further comprising an etching mask film that is formed in contact with the absorber film.

5. The reflective mask blank of claim 4 wherein the absorber film consists of
the main region, and a substrate-side region that is in contact with the substrate-side of the main region,
the main region, and a surface-side region that is in contact with the side remote from the substrate of the main region, or
the main region, a substrate-side region that is in contact with the substrate-side of the main region, and a surface-side region that is in contact with the side remote from the substrate of the main region,
the substrate-side region comprises tantalum (Ta), nitrogen (N) and an element comprised in the protection film, and has a thickness of not more than 1 nm, and
the surface-side region comprises tantalum (Ta), nitrogen (N) and an element comprised in the etching mask film, and has a thickness of not more than 1 nm.

6. The reflective mask blank of claim 5 wherein the surface-side layer further comprises oxygen (O).

7. The reflective mask blank of any one of claims 1 to 6 wherein the absorber film has a thickness of not less than 50 nm and not more than 80 nm.

8. The reflective mask blank of any one of claims 1 to 7 wherein in the main region, the layer remotest from the substrate is the high nitrogen content layer.

9. The reflective mask blank of any one of claims 1 to 8 wherein the absorber film has a reflectance of not more than 35% with respect to light having a wavelength of 193 to 260 nm.

10. The reflective mask blank of any one of claims 1 to 9 wherein the absorber film consists of said at least one low nitrogen content layer and said at least one high nitrogen content layer.

11. The reflective mask blank of claim 10 wherein in the main region, the layer closest to the substrate is the low nitrogen content layer that has a thickness of not less than 0.3 nm and not more than 2 nm, and each layer other than the layer closest to the substrate is the high nitrogen content layer.

12. The reflective mask blank of any one of claims 1 to 11 wherein the main region has a structure in which the low nitrogen content layers and the high nitrogen content layers are alternately laminated, and each layer has a thickness of not less than 3 nm and not more than 30 nm.

13. The reflective mask blank of any one of claims 1 to 12 wherein the absorber film has a surface roughness Sq of not more than 0.6 nm.

14. The reflective mask blank of any one of claims 1 to 13 wherein the absorber film is a film that causes a warpage change ΔTIR of the substrate in the range of +0.2 µm due to tensile stress to -0.5 µm due to compressive stress when the absorber film is formed on a main surface of a substrate having dimensions of 152 mm square and 6.35 mm thick.

15. The reflective mask blank of any one of claims 1 to 14 wherein the protection film comprises ruthenium (Ru).
